(19) Europäisches Patentamt / European Patent Office / Office européen des brevets

(11) **EP 3 510 645 B1**

(12) **FASCICULE DE BREVET EUROPEEN**

(45) Date de publication et mention
de la délivrance du brevet:
**24.02.2021 Bulletin 2021/08**

(21) Numéro de dépôt: **17765410.0**

(22) Date de dépôt: **08.09.2017**

(51) Int Cl.:
*H01M 2/02* (2006.01)   *H01M 10/42* (2006.01)
*H01M 2/10* (2006.01)   *H01M 2/30* (2006.01)
*H01M 2/34* (2006.01)   *H02H 7/00* (2006.01)
*H02J 7/00* (2006.01)

(86) Numéro de dépôt international:
**PCT/EP2017/072537**

(87) Numéro de publication internationale:
**WO 2018/046635 (15.03.2018 Gazette 2018/11)**

(54) **PROTECTION D'UN DISPOSITIF D'ACCUMULATION D'ENERGIE ELECTRIQUE**

SCHUTZ EINES ELEKTRISCHEN ENERGIELAGERGERÄTS

PROTECTION OF AN ELECTRIC ENERGY STORAGE DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.09.2016 FR 1601330**
**04.11.2016 FR 1660667**

(43) Date de publication de la demande:
**17.07.2019 Bulletin 2019/29**

(73) Titulaire: **Thales**
**92400 Courbevoie (FR)**

(72) Inventeurs:
• **DUBOIS, Eric, Ravindranath**
**78401 CHATOU CEDEX (FR)**
• **KHERBOUCHI, Hocine**
**78401 CHATOU CEDEX (FR)**
• **BOSSON, Joël**
**78401 CHATOU CEDEX (FR)**

(74) Mandataire: **Marks & Clerk France**
**Immeuble "Visium"**
**22, avenue Aristide Briand**
**94117 Arcueil Cedex (FR)**

(56) Documents cités:
**EP-A1- 2 219 295       US-A1- 2011 013 429**
**US-A1- 2012 141 848**

## Description

L'invention concerne la protection d'un dispositif d'accumulation d'énergie électrique contre des agressions électromagnétiques.

Pour accumuler de l'énergie électrique et permettre l'alimentation d'équipements, de nombreux types d'accumulateur d'énergie électrique sont actuellement disponibles tels que notamment de batteries de type lithium ion, cadmium nickel... On peut également mettre en oeuvre et des condensateurs électrochimiques de puissance comme accumulateur. Généralement, les dispositifs échangent de l'énergie électrique sous forme d'une tension continue.

Ces dispositifs d'accumulation sont sensibles aux perturbations électromagnétiques, notamment celles transitant sur les lignes électriques raccordées aux dispositifs d'accumulation. Les perturbations, souvent de type haute fréquence, sollicitent les dispositifs d'accumulation ce qui entraine un vieillissement prématuré des dispositifs.

Récemment avec l'augmentation de l'utilisation de dispositifs d'accumulation, des explosions, parfois inexpliquées, ont été constatées. A défaut de trouver la cause de ces explosions et pour en limiter les conséquences, on peut avoir recours à un confinement métallique des cellules élémentaires de stockage contenues dans les dispositifs d'accumulation. Le confinement métallique n'exclut pas les destructions des cellules mais permet de contenir la propagation des fumées et des flammes issues de l'explosion. On a également recours à une augmentation des épaisseurs du confinement métallique et des séparateurs à l'intérieur des dispositifs d'accumulation et à l'intérieur des dispositifs et notamment entre les bornes des dispositifs. Une cause probable d'explosion ou tout au moins d'échauffements excessifs réside dans la présence de perturbations électromagnétiques dans les équipements raccordés aux dispositifs d'accumulation ou à l'intérieur même des dispositifs d'accumulation.

Pris isolément, le dispositif d'accumulation n'est généralement pas ou peu susceptible aux perturbations électromagnétiques. L'équipement dans lequel est installé le dispositif d'accumulation peut comporter des éléments parasites tels que les inductances de câblages qui peuvent résonner avec les capacités parasites présentes entre le boitier et les cellules élémentaires de stockage.

La mise en place de condensateurs entre les bornes du dispositif d'accumulation d'énergie et son boitier peut paraitre suffisante pour évacuer des perturbations hautes fréquences. Cependant, la présence d'un tel composant, couplé avec inductances de câblages entraine des résonnances qui peuvent être nocives. Au mieux, les condensateurs vont modifier la fréquence de résonnance mais au risque d'amplifier la résonnance. A la fréquence de résonance, les courants induits par des ondes électromagnétiques sont grandement amplifiés et provoquent des échauffements très élevés particulièrement sur les couches périphériques des cellules élémentaires de stockage. Ces échauffements peuvent conduire à la destruction des cellules

Le document US 2011/013429 A1 divulgue une batterie reliée à un onduleur pour un véhicule électrique. La batterie (qui fournit un courant DC) est protégée d'une perturbation électronique tendant à pénétrer dans le boîtier de la batterie par au moins l'une des bornes par des condensateurs reliés d'une part aux bornes de la batterie, et d'autre part à l'intérieur du boîtier. De plus, un condensateur à l'extérieur du boîtier relie les bornes positives et négative de celui-ci. Les condensateurs forment des filtres de type passe haut.

L'invention vise à pallier tout ou partie des problèmes cités plus haut en proposant un nouveau dispositif d'accumulation d'énergie électrique comprenant des moyens de protection contre des perturbations électromagnétiques. Ces moyens permettent d'éviter ou tout au moins de limiter et d'atténuer la propagation des perturbations à l'intérieur du dispositif d'accumulation. Ces moyens forment une barrière permettant de bloquer les perturbations aux bornes du dispositif d'accumulation pour éviter qu'elles n'atteignent les cellules élémentaires de stockage des dispositifs. Plus précisément, l'invention propose la mise en place d'au moins une résistance entre une des bornes du dispositif d'accumulation d'énergie et son boitier. Cette résistance permet de limiter l'effet des résonnances dues aux inductances et capacités parasites en permettant leur amortissement.

A cet effet, l'invention a pour objet un dispositif d'accumulation d'énergie électrique comme défini dans la revendication 1.

L'impédance est disposée l'intérieur du boitier et relie une première des bornes au boitier, la première impédance formant un filtre de type passe haut configuré pour évacuer vers le boitier une perturbation électromagnétique tendant à se propager par la première borne. l'impédance est appelée première impédance, et avantageusement, le dispositif comprend en outre, à l'intérieur du boitier, une seconde impédance ayant au moins une composante résistive supérieure à 1 ohm et reliant une seconde des bornes au boitier, la seconde impédance formant un filtre de type passe haut configuré pour évacuer vers le boitier une perturbation électromagnétique tendant à se propager par la seconde borne.

Avantageusement, le dispositif comprend en outre, à l'intérieur du boitier, une troisième impédance ayant au moins une composante résistive supérieure à 1 ohm et formant un filtre de type passe haut et reliant les deux bornes entre elles.

Le dispositif peut comprendre, à l'intérieur du boitier, plusieurs cellules de stockage d'énergie électrique reliés aux bornes et des impédances chacune associée à une des cellules de stockage d'énergie électrique et ayant au moins une composante résistive supérieure à 1 ohm.

La ou les impédances comprennent chacune un condensateur et une résistance reliés en série. La ou les impédances peuvent comprendre plusieurs résistances reliées en parallèle et/ou plusieurs inductances L reliées en série ou en parallèle.

Avantageusement, le dispositif comprend un moyen de comparaison d'une tension présente au point commun du condensateur et de la résistance de la première impédance et/ou de la seconde impédance à une tension de référence et un moyen d'information d'un écart entre la tension présente au point commun et de la tension de référence.

Selon une variante du dispositif l'impédance est appelée quatrième impédance et forme un filtre passe bas connecté en série avec un conducteur reliant une première des bornes et l'au moins une cellule de stockage.

Le dispositif comprend avantageusement une cinquième impédance formant un filtre passe bas connecté en série avec un conducteur reliant une seconde des bornes et l'au moins une cellule de stockage.

La quatrième et la cinquième impédances peuvent être formées chacune d'un enroulement raccordé en série entre l'au moins une cellule et la borne respective. Le dispositif peut comprendre un circuit magnétique commun à la quatrième et à la cinquième impédances.

Avantageusement, le dispositif comprend en outre un moyen de test de la quatrième impédance et le cas échéant de la cinquième impédance.

La quatrième et le cas échéant de la cinquième impédance peuvent être formées chacune d'un enroulement primaire et le moyen de test peut comprendre un enroulement secondaire couplé à l'enroulement primaire pour chacune des quatrième et le cas échéant de la cinquième impédance.

La quatrième impédance et le cas échéant de la cinquième impédance peuvent être formées d'un matériau ferromagnétique entourant le conducteur reliant la borne considérée et l'au moins une cellule de stockage.

L'invention sera mieux comprise et d'autres avantages apparaîtront à la lecture de la description détaillée d'un mode de réalisation donné à titre d'exemple, description illustrée par le dessin joint dans lequel :

la figure 1 représente schématiquement un dispositif d'accumulation d'énergie électrique selon l'invention ;
les figures 2a, 2b, 2c, 3a et 3b représentent plusieurs exemples d'impédances pouvant être mises en œuvre dans le dispositif de la figure 1 (les figures 2a et 3a représentant des variantes non revendiquées) ;
la figure 4 représente en perspective un exemple de disposition de composants du dispositif de la figure 1 ;
la figure 5 représente une variante d'un dispositif d'accumulation d'énergie électrique selon l'invention.

Par souci de clarté, les mêmes éléments porteront les mêmes repères dans les différentes figures.

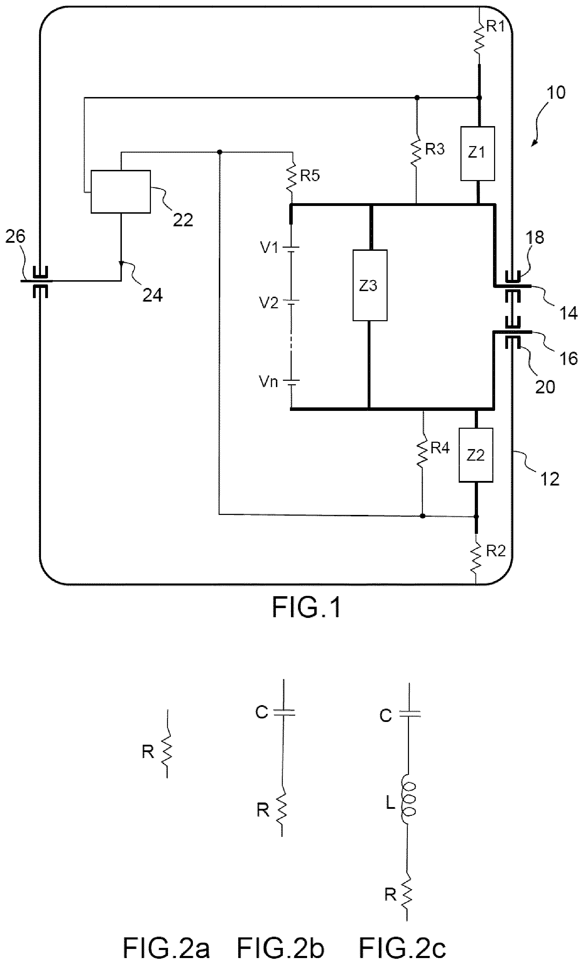

La figure 1 représente schématiquement un dispositif 10 d'accumulation d'énergie électrique. Le dispositif 10 peut être intégré dans n'importe quel système embarqué, notamment à bord d'un aéronef.

Le dispositif 10 comprend un boitier 12 à l'intérieur duquel se trouvent les composants du dispositif 10. Le boitier 12 est en matériau conducteur de l'électricité. Il est par exemple formé d'une enveloppe métallique ou en tout autre matériau conducteur. On peut par exemple réaliser le boitier en fibres de carbone noyées dans une résine. Le dispositif 10 comprend un ou plusieurs éléments de stockage d'énergie électrique disposés dans le boitier 12. Différents types d'élément de stockage peuvent être mis en œuvre dans le cadre de l'invention, comme par exemple des batteries d'accumulateur ou des condensateurs électrochimiques.

Sur la figure 1, plusieurs batteries V1, V2...Vn, formant chacune un élément de stockage, sont raccordées en série afin d'élever la tension d'utilisation du dispositif 10. Lorsque plusieurs éléments de stockage sont mis en œuvre, il est possible de les raccorder différemment, notamment en parallèle. Il est bien sûr possible de réaliser des raccordements à la fois en série et en parallèle de plusieurs éléments de stockage. Le dispositif comprend deux bornes 14 et 16 permettant de raccorder le dispositif 10 à un réseau extérieur. Les bornes 14 et 16 sont disposées en traversée du boitier 12. Les bornes 14 et 16 sont isolées électriquement du boitier 12. Un isolant 18 entoure la borne 14 et un isolant 20, la borne 16. Les isolants 18 et 20 peuvent assurer le maintien mécanique de leur borne respective 14 et 16 par rapport au boitier 12. Généralement, les dispositifs de stockage d'énergie fonctionnent en courant continu. La borne 14 forme la borne positive et la borne 16, la borne négative du dispositif 10. Dans le cadre de l'invention, Il est possible de mettre en œuvre un dispositif de stockage d'énergie fonctionnent en courant alternatif.

Selon l'invention, le dispositif 10 comprend, à l'intérieur du boitier 12, au moins une impédance reliant une des deux bornes 14 ou 16 au boitier 12. L'impédance possède au moins une composante résistive supérieure à 1 ohm afin de permettre l'amortissement de résonnances dues aux couplages d'inductances et de capacités présentes dans le dispositif lui-même et dans son environnement. Les inductances et les capacités peuvent être des composants spécifiques ou des éléments parasites dus notamment aux fils de câblage. L'impédance peut être réalisée sous forme d'une résistance reliant une des bornes 14 ou 16 directement au boitier 12. Lorsque le potentiel du boitier 12 est égal ou proche de celui d'une des bornes, par exemple la borne négative 16, la résistance permet l'amortissement des résonnances sans décharger un dispositif fonctionnant en courant continu. A cet effet, il est important de conserver la borne 16 isolée du boitier 12 au niveau du passage de la borne 16 en traversée du boitier 12 afin de ne pas courcircuiter la résistance. Cependant une simple résistance placée directement entre la borne positive 14 et le boiter 12 tendrait à décharger le dispositif. Ceci peut être acceptable pour des dispositifs d'accumulation fonctionnant avec des cycles courts, comme par exemple avec des super condensateurs. Pour éviter cette décharge, on dispose en série de la résistance un condensateur. L'impédance forme alors un filtre de type passe haut configuré pour évacuer vers le boitier une perturbation électromagnétique tendant à se propager par la borne reliée au boitier par l'impédance. La définition d'une fréquence de coupure du filtre passe haut est faite en fonction du type de perturbation que l'on souhaite filtrer. Pour un dispositif 10 fonctionnant en courant continu, la fréquence de coupure peut être très basse, de l'ordre du kHz. Pour un dispositif fonctionnant en courant alternatif, la fréquence de coupure doit être supérieure à la fréquence du courant alternatif. Si une seule des bornes 14 ou 16 est reliée au boitier, on choisit celle dont le circuit externe au dispositif auquel la borne est raccordée est le plus susceptible de véhiculer des perturbations. Il s'agit généralement de perturbations haute fréquence que le circuit peut véhiculer. Ces perturbations peuvent être issues de composants du circuit externe ou provenant de rayonnement électromagnétique reçu par les conducteurs du circuit externe. Dans le cas d'un dispositif 10 fonctionnent en courant continu, la borne négative peut être raccordée à une masse du circuit externe. Cette masse peut être formée par un grand nombre de pièces mécaniques dont il est nécessaire de fixer le potentiel par exemple en assurant une bonne métallisation de leur surface. Ces pièces mécaniques peuvent constituer une antenne captant toute sorte de rayonnement électromagnétique. Il est donc avantageux de relier la borne négative 16 au boitier 12 par l'intermédiaire d'une impédance formant un filtre passe haut.

Dans la pratique, le dispositif de stockage 10 peut être raccordé à différents circuits externes et lors de la conception du dispositif il est avantageux de protéger les deux bornes 14 et 16 des perturbations électromagnétiques afin de standardiser la fabrication de dispositifs 10. A cet effet, les deux bornes 14 et 16 sont reliées chacune au boitier 12 au travers d'une impédance comprenant chacune une composante résistive et formant chacune avantageusement un filtre passe haut. Sur la figure 1, une impédance Z1 relie la borne 14 au boitier 10 et une impédance Z2 relie la borne 16 au boitier 10.

En cas de panne d'une des impédances Z1 ou Z2, notamment en cas de coupure de la liaison entre le boitier 12 et la borne respective, la protection contre les perturbations n'est plus assurée. Avantageusement, pour pallier ce problème, le dispositif 10 comprend une troisième impédance Z3 reliant les deux bornes 14 et 16. La troisième impédance Z3 comprend également une composante résistive et forme avantageusement un filtre de type passe haut. Ainsi en cas de casse de l'impédance Z1, des perturbations présentes sur la borne 14 peuvent tout de même être évacuées vers le boitier 12 au travers des impédances Z3 et Z2 disposées en série. De même, en cas de casse de l'impédance Z2, les perturbations présentes sur la borne 16 transitent vers le boitier 12 au travers des impédances Z3 et Z1 disposées en série. Le dispositif est ainsi tolérant à une panne sur l'une des impédances Z1 ou Z2. Une panne sur l'impédance Z3 est également acceptable, l'évacuation des perturbations se fait alors par l'une des impédances Z1 ou Z2. Une panne peut être provoquée par une défaillance d'un composant d'une des impédances Z1, Z2 ou Z3. Cette défaillance peut être due au composant lui-même ou à une surcharge du composant lors de son utilisation.

Les figures 2a, 2b et 2c représentent trois exemples d'impédances pouvant être mises en oeuvre dans le dispositif de la figure 1. La figure 2a, non revendiquée, représente une résistance R seule, la figure 2b représente un condensateur C en série avec une résistance R et la figure 2c représente un condensateur C, une inductance L et une résistance R, tous trois en série.

Un condensateur seul possédant une résistance série importante peut suffire pour réaliser une impédance telle que Z1, Z2 ou Z3. Pour réaliser un filtre de type passe haut, la résistance série du condensateur forme l'équivalent d'une résistance et d'un condensateur connecté en série tel que représenté sur la figure 2b. Plus précisément, dans le cas des impédances Z1 et Z2 la résistance série peut être répartie entre d'une part le conducteur reliant le borne concernée et le condensateur et d'autre part le conducteur reliant le condensateur au boitier 12. Dans le cas de l'impédance Z3, la résistance peut être répartie entre les deux conducteurs reliant le condensateur C à chacune des bornes 14 et 16.

Afin d'augmenter la valeur de la résistance R associée au condensateur C, il est possible d'ajouter un composant spécifique résistif en série avec le condensateur C tel que représenté sur la figure 2b.

De même, les conducteurs présentent généralement par eux mêmes une inductance qui peut être de l'ordre d'un nH par mm de longueur du conducteur. Il est possible d'augmenter la valeur de cette inductance en ajoutant un composant inductif L en série avec le condensateur C et la résistance R, comme représenté sur la figure 2c. Il est bien sur possible de ne connecter en série qu'un condensateur C et un composant inductif L, la résistance étant assurée par les résistances séries de chaque composant L et C.

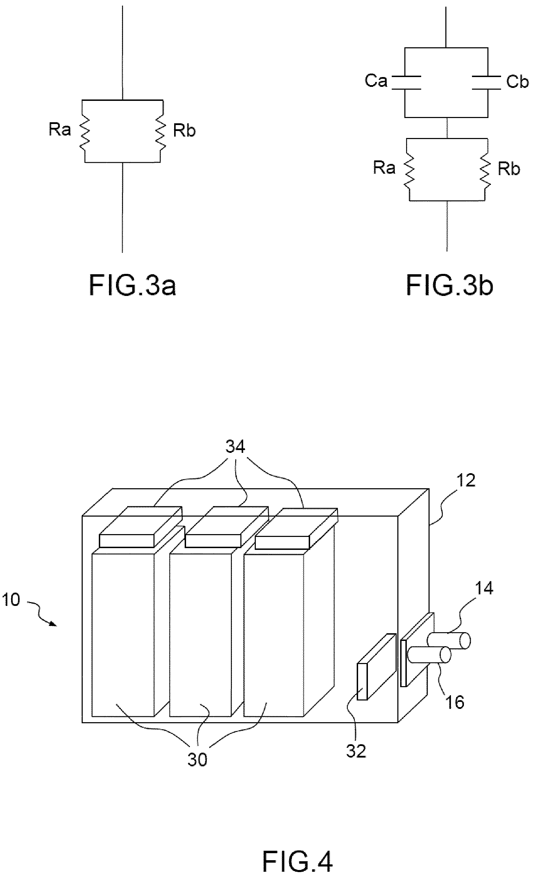

Les figures 3a et 3b représentent des variantes d'impédances dans lesquelles plusieurs résistances Ra et Rb et éventuellement plusieurs condensateurs Ca et Cb sont raccordées en parallèle. La figure 3a représente une variante non revendiquée. Toutes les résistances présentent dans la figure 1 peuvent être associées en série et parallèle. A l'image de la figure 3b, il est également possible d'ajouter plusieurs composants inductifs L raccordés en série ou en parallèle. Ces raccordements en parallèle permettent la redondance des composants et assure une partie de la sécurité. Ainsi, lorsque l'un d'entre eux subit une panne, l'autre ou les autres permettent à l'impédance de remplir sa fonction. Les caractéristiques de l'impédance sont altérées mais la fonction reste remplie. Sur la figure 3b, un point commun des condensateurs Ca et Cb est raccordé à un point commun des résistances Ra et Rb. Alternativement, il est possible de raccorder en parallèle plusieurs ensemble disjoints formé chacun par une résistance R et un condensateur C. Un composant inductif L peut également être ajouté en série et ou en parallèle dans chaque ensemble disjoint.

Dans l'exemple représenté deux composants de chaque type sont raccordés en parallèle. Il est bien entendu possible de prévoir un plus grand nombre de composants raccordés en parallèle.

Des tests réalisés en interne ont montré que la valeur minimale de la composante résistive de l'impédance Z1, ainsi que des impédances Z2 et Z3 lorsqu'elles sont présentes est de l'ordre de 1Ω afin d'assurer un amortissement suffisant des résonnances de type LC. De façon générale, la résistance R d'amortissement peut être définie par :

$$R = K \sqrt{\frac{L}{C}}$$

K est un coefficient dépendant de l'environnement. K peut être défini en résolvant des équations différentielles du comportement électromagnétique des composants en présence. K peut également être défini par simulation, par exemple en utilisant un logiciel de simulation de circuits électroniques analogiques comme par exemple SPICE (Simulation Program with Integrated Circuit Emphasis) développé par l'université de Californie à Berkeley aux Etats Unis. L représente l'inductance équivalente parasite du dispositif d'accumulation d'énergie et de son environnement. C représente la capacité équivalente parasite du dispositif d'accumulation d'énergie et de son environnement. La valeur de la résistance est choisie en fonction de l'environnement du dispositif d'accumulation en utilisation. Par exemple, dans un environnement défini en interne pour une batterie de type lithium-ion de 28V et de 56A.h mise en œuvre dans un aéronef, une valeur de l'ordre de 10Ω peut être retenue. Associé à cette résistance une capacité de 100nF peut également être retenue. De façon plus générale, on a obtenu une bonne protection d'un dispositif d'accumulation, avec des valeurs de comprises entre 1 et 1000 Ω, et des valeurs de condensateur raccordé en série avec la résistance comprises entre 10nF et 1μF.

On note que pour obtenir des valeurs de résistances supérieures à 1Ω, la résistance usuelle de fils de câblage est loin d'être suffisante. En raccordant un condensateur seul entre une des bornes 14 ou 16 et le boitier 12, les fils de raccordement pourraient au mieux générer une résistance de l'ordre de quelques milli-Ohm. La résistance des fils de câblage est beaucoup trop faible pour générer l'amortissement nécessaire. Une telle résistance serait incapable de dissiper par effet Joule l'énergie d'une perturbation électromagnétique tendant à pénétrer dans le boitier 12. Par exemple, un fil de cuivre de diamètre 0,254mm possède une résistance linéique de 338mΩ/m. Même en utilisant 10cm de fil, on obtient 34 mΩ, ce qui beaucoup trop faible pour amortir des perturbations d'un environnement aéronautique.

La présence d'un composant résistif ou résistance R spécifique peut être mise à profit pour tester les impédances. Pour une impédance donnée, ce test est avantageusement effectué en comparant la tension mesurée dans l'impédance au point commun de la résistance R et du condensateur C à une tension de référence. Sur la figure 1, une résistance R1 est représentée en série avec l'impédance Z1 et une résistance R2 est représentée en série avec l'impédance Z2. Il est bien entendu que les résistances R1 et R2 peuvent former à elles seules la composante résistive de l'impédance considérée et participent à la fonction de filtrage passe haut des impédances Z1 et Z2. La mesure réalisée pour le test est faite au point commun de l'impédance Z1 ou Z2 et de sa résistance associée en série R1 ou R2. Si l'impédance comprend déjà une résistance, il est bien sûr possible de réaliser la mesure à l'une des bornes de cette résistance. Un défaut dans le condensateur C ou dans la résistance R modifie la tension mesurée. Il est possible d'améliorer la mesure en plaçant une résistance en parallèle du condensateur. Par exemple sur la figure 1, une résistance R3 est disposée en parallèle de l'impédance Z1 et une résistance R4 est disposée en parallèle de l'impédance Z2. Les résistances R1 et R3 forment un diviseur de tension au point central duquel la mesure est effectuée. Il en est de même pour les résistances R4 et R2.

Il est possible de prévoir un moyen de comparaison propre à chaque impédance Z1, Z2 ou Z3. Pour simplifier le dispositif, Il est avantageux de prévoir un moyen de comparaison commun à plusieurs impédances. Par exemple sur la figure 1, un moyen de comparaison 22 compare une tension de l'impédance Z1 et une tension de l'impédance Z2. Une résistance R5 est disposée entre la borne positive 14 et le point de comparaison de l'impédance Z2 afin de ramener la tension mesurée dans l'impédance Z2 à une valeur voisine de celle mesurée dans l'impédance Z1.

Associé au moyen de comparaison 22, le dispositif 10 comprend de plus un moyen d'information 24 d'un écart entre un résultat de la comparaison et un résultat attendu. Ce moyen d'information 24 peut être de toute nature, signal sonore, visuel ou simplement un signal électrique disponible sur une borne 26 sortant du boitier 12. Le signal électrique peut être utilisé par un contrôleur extérieur ou intérieur au dispositif. En cas de signal indiquant une panne des moyens de protection électromagnétique, notamment une défaillance d'une des impédances Z1, Z2 ou Z3, le contrôleur peut déconnecter le dispositif 10 du réseau dans lequel il est mis en œuvre. Néanmoins le dispositif 10 est sécurisé par la redondance des composants et des filtres passe haut.

La figure 4 représente en perspective un exemple de disposition de composants du dispositif 10 qui comprend plusieurs cellules élémentaires de stockage d'énergie 30 disposées dans le boitier 12. Sur la figure 4 trois cellules 30 sont représentées. L'invention peut être mise en œuvre quelque soit le nombre de cellules 30. Le raccordement des cellules 30 vers les bornes 14 et 16 n'est pas représenté ainsi que d'éventuelles cartes électroniques du dispositif. Il est possible d'associer les différentes cellules 30 en série, en parallèle ou en combinant un raccordement en série et en parallèle.

Un premier bloc de protection électromagnétique 32 est représenté au voisinage des bornes 14 et 16. Le bloc 32 comprend le ou les impédances Z1, Z2, et, Z3, et éventuellement les résistances R1, R2, R3, R4 et R5 et les moyens de comparaison 22 et d'information 24. Ce bloc 32 est disposé le plus près possible des bornes 14 et 16 afin de limiter le cheminement de perturbations électromagnétiques à l'intérieur du boitier 12.

Pour améliorer encore la protection du dispositif 10 vis-à-vis de perturbations électromagnétiques, associée à chaque cellule 30, le dispositif peut comprendre au moins une impédance telle que décrite précédemment. Sur la figure 4, associé à chaque cellule 30, un bloc de protection électromagnétique 34 est représenté. Chaque bloc 34 comprend comme le bloc 32, le ou les impédances Z1, Z2, et, Z3, et éventuellement les résistances R1, R2, R3, R4 et R5 et les moyens de comparaison 22 et d'information 24. Chaque bloc 34 est disposé au plus près de la cellule 30 à laquelle il est associé.

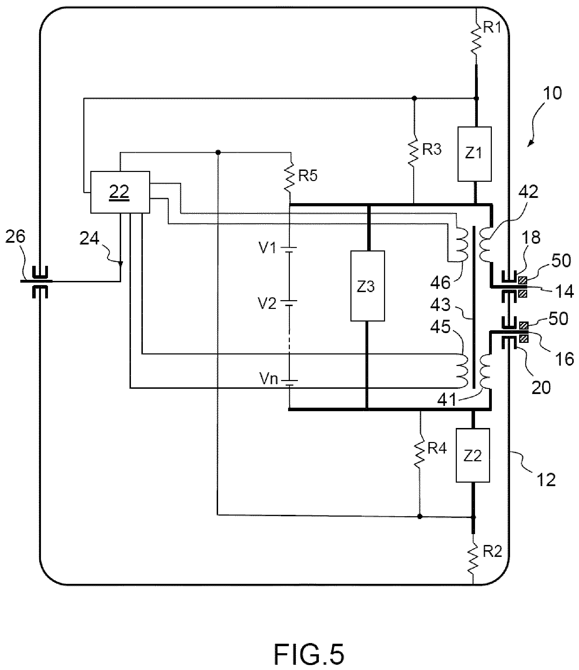

La figure 5 représente une variante d'un dispositif 40 d'accumulation d'énergie électrique. On y retrouve tous les éléments déjà décrits à l'aide de la figure 1. Le dispositif 40 comprend de plus au moins une impédance formant un filtre passe bas connecté en série avec un conducteur reliant une des bornes 14 ou 16 et la ou les cellules de stockage. Chaque impédance permet de dissiper l'énergie d'une perturbation électromagnétique haute fréquence en ne laissant transiter de ou vers les cellules de stockage que les signaux basse fréquence utiles, c'est-à-dire l'énergie stockée dans les cellules. La fréquence de coupure du filtre est choisie en fonction de la fréquence du courant nominal utilisé pour le stockage d'énergie dans le dispositif.

Chaque filtre passe bas est par exemple formé d'une inductance, comme par exemple un enroulement, raccordée en série avec la borne 14 ou 16 respective. Alternativement, il est possible de former le filtre passe bas au moyen d'un enroulement ou d'un matériau ferromagnétique 50 disposé autour du conducteur reliant la ou les bornes considérées. On peut notamment utiliser une ferrite ou des matériaux en alliage de fer et de nickel et/ou de silicium, et ou/de cobalt... Ces matériaux possèdent par exemple une structure amorphe ou cristalline. Ces différents modes de réalisation, enroulement ou matériau ferromagnétique, sont adaptables à l'inductance représentée sur la figure 2c.

Les matériaux ferromagnétiques présentent une perméabilité magnétique que l'on modéliser de façon complexe souvent notée de la façon suivante :

$$\mu = \mu_S{}' - j\mu_S{}''$$

La partie réelle de la perméabilité magnétique représente la composante purement inductive apportée par le matériau. La partie imaginaire représente les pertes et peut être assimilée à une résistance série qui est mise à profit pour réaliser l'amortissement souhaité. Cette résistance se combine avec celle reliée au boitier 12. Dans la détermination de la composante résistive de l'impédance configurée pour dissiper l'énergie de la perturbation électromagnétique, la partie imaginaire de la perméabilité magnétique est prise en compte.

Le ou les impédances formant un filtre passe bas peuvent être situées à l'intérieur du boitier 12 en série entre la borne considérée et la cellule de stockage. Il est également possible de disposer cette ou ces impédances à l'extérieur du boitier 12 et avantageusement, au plus près de celui-ci, c'est-à-dire au contact du boitier 12 afin de limiter la longueur des conducteurs électriques situés entre le ou les impédances et la ou les cellules de stockage, notamment sur la portion de ces conducteurs situés hors du boitier 12. La possibilité de disposer le ou les impédances à l'extérieur du boitier 12 s'applique aussi aux impédances de type passe haut décrites à l'aide de la figure 1.

Comme pour les impédances de type passe haut, il est possible de ne disposer qu'une seule impédance de type passe bas connecté en série avec la borne choisie 14 ou 16. Mais avantageusement, on dispose une impédance de type passe bas associé à chacune des bornes 14 et 16.

Dans l'exemple représenté sur la figure 5, un enroulement 41 est disposé à l'intérieur du boitier 12 en série entre la borne négative 16 et la borne négative de la batterie Vn. Un enroulement 42 est disposé à l'intérieur du boitier 12 en série entre la borne positive 18 et la borne positive de la batterie V1. Les deux enroulements 41 et 42 peuvent être indépendants l'un de l'autre. Avantageusement, le dispositif comprend un circuit magnétique 43 commun aux deux enroulements 41 et 42, ce qui permet de mieux dissiper les perturbations de mode différentiel entre les deux bornes 14 et 16.

Comme pour les impédances de type passe haut, le dispositif 40 peut comprendre un moyen de test des impédances 41 et 42. Ce moyen de test comprend par exemple un enroulement secondaire 45 couplé avec l'enroulement 41 appelé enroulement primaire et un enroulement secondaire 46 couplé avec l'enroulement 42, également appelé enroulement primaire. Pour chaque impédance 41 et 42 un enroulement secondaire est couplé avec un enroulement primaire permettant de mesurer le courant qui y circule et de le comparer à une valeur attendue, en utilisant par exemple le comparateur 22.

Pour cela les enroulements secondaires sont raccordés au comparateur 22.

Des filtres passe haut ont été décrits à l'aide de la figure 1 et des filtre passe bas à l'aide de la figure 5. Il est bien entendu possible de disposer soit un seul des deux types de filtre soit les deux types de filtre dans le dispositif. Il est également possible de mettre en œuvre des filtres de type bouchon (passe bande en parallèle ou coupe bande en série) adaptés à une perturbation identifiée dans la bande du filtre.

**Revendications**

1. Dispositif d'accumulation d'énergie électrique (10) comprenant un boitier (12) en matériau conducteur de l'électricité, au moins une cellule (30) de stockage d'énergie électrique disposée dans le boitier (12) et deux bornes (14, 16) disposées en traversée du boitier (12), les bornes (14, 16) étant isolées électriquement du boitier (12) au niveau du passage des bornes (14, 16) en traversée du boitier (12), les bornes (14, 16) permettant un transfert d'énergie électrique entre l'au moins une cellule (30) de stockage et l'extérieur du dispositif (10), **caractérisé en ce que** le dispositif (10) comprend en outre, un composant spécifique (Z1, Z2, Z3, 34, 41, 42) formant une impédance disposée l'intérieur du boitier (12), reliant une première des bornes (14, 16) au boitier (12), et formant un filtre de type passe haut configuré pour évacuer vers le boitier (12) une perturbation électromagnétique tendant à se propager par la première borne (14, 16) et à pénétrer dans le boitier (12), le composant spécifique (Z1, Z2, Z3, 34, 41, 42) comprennant un condensateur (C) et une résistance (R) reliés en série, la résistance (R) ayant une valeur supérieure à 1 ohm, configuré pour dissiper l'énergie de la perturbation électromagnétique.

2. Dispositif selon la revendication 1, **caractérisé en ce que** l'impédance est appelée première impédance, et **en ce qu'**il comprend, à l'intérieur du boitier (12), une seconde impédance (Z2) ayant au moins une composante résistive supérieure à 1 ohm et reliant une seconde des bornes (14) au boitier (12), la seconde impédance (Z2) formant un filtre de type passe haut configuré pour évacuer vers le boitier (12) une perturbation électromagnétique tendant à se propager par la seconde borne (14).

3. Dispositif selon l'une des revendications précédentes, **caractérisé en ce qu'**il comprend, à l'intérieur du boitier (12), une troisième impédance (Z3) ayant au moins une composante résistive supérieure à 1 ohm et formant un filtre de type passe haut et reliant les deux bornes (14, 16) entre elles.

4. Dispositif selon l'une des revendications précédentes, **caractérisé en ce qu'**il comprend, à l'intérieur du boitier, plusieurs cellules (30) de stockage d'énergie électrique reliés aux bornes (14, 16) et des impédances (34) chacune associée à une des cellules (30) de stockage d'énergie électrique, et ayant au moins une composante résistive supérieure à 1 ohm.

5. Dispositif selon l'une des revendications précédentes, **caractérisé en ce que** la ou les impédances (Z1, Z2, Z3, 34) comprennent chacune plusieurs condensateurs (Ca, Cb) reliés en parallèle.

6. Dispositif selon l'une des revendications précédentes, **caractérisé en ce que** la ou les impédances (Z1, Z2, Z3, 34) comprennent chacune plusieurs résistances (Ra, Rb) reliées en parallèle.

7. Dispositif selon l'une des revendications précédentes, **caractérisé en ce que** la ou les impédances (Z1, Z2, Z3, 34) comprennent chacune plusieurs inductances L reliées en série ou en parallèle.

8. Dispositif selon l'une des revendications précédentes, **caractérisé en ce qu'**il comprend un moyen de comparaison (22) d'une tension présente au point commun du condensateur (C) et de la résistance (R) à une tension de référence et un moyen d'information (24) d'un écart entre la tension présente au point commun et de la tension de référence.

9. Dispositif selon l'une des revendications précédentes, **caractérisé en ce qu'**il comprend un moyen de comparaison (22) d'une tension présente au point commun du condensateur (C) et de la résistance (R) de la première impédance (Z1) et d'une tension présente au point commun du condensateur (C) et de la résistance (R) de la seconde impédance (Z2) et un moyen d'information (24) d'un écart entre un résultat mesuré de la comparaison et un résultat attendu.

10. Dispositif selon la revendication 1, **caractérisé en ce qu'**il comprend une impédance supplémentaire, appelée quatrième impédance (41), formant un filtre passe bas connecté en série avec un conducteur reliant une première des bornes (14, 16) et l'au moins une cellule (30) de stockage.

11. Dispositif selon la revendication 10, **caractérisé en ce que** le dispositif comprend, une cinquième impédance (42) formant un filtre passe bas connecté en série avec un conducteur reliant une seconde des bornes (14, 16) et l'au moins une cellule (30) de stockage.

12. Dispositif selon la revendication 11, **caractérisé en ce que** la quatrième (41) et la cinquième (42) impédances sont formées chacune d'un enroulement raccordé en série entre l'au moins une cellule (30) et la borne (14, 16) respective, et **en ce que** le dispositif comprend un circuit magnétique (43) commun à la quatrième (41) et à la cinquième (42) impédances.

13. Dispositif selon l'une des revendications 10 à 12, **caractérisé en ce qu'**il comprend un moyen de test (22, 45, 46) de la quatrième impédance (41) et le cas échéant de la cinquième impédance (42).

14. Dispositif selon la revendication 13, **caractérisé en ce que** la quatrième impédance (41) et le cas échéant de la cinquième impédance (42) sont formées chacune d'un enroulement primaire et **en ce que** le moyen de test comprend un enroulement secondaire (45, 46) couplé à l'enroulement primaire pour chacune des quatrième impédance et le cas échéant de la cinquième impédance.

15. Dispositif selon l'une quelconque des revendications 10 ou 11, **caractérisé en ce que** la quatrième impédance (41) et le cas échéant de la cinquième impédance (42) sont formées d'un matériau ferromagnétique entourant le conducteur reliant la borne (14, 16) considérée et l'au moins une cellule (30) de stockage.

**Patentansprüche**

1. Gerät (10) zum Speichern von elektrischer Energie umfassend ein Gehäuse (12) aus elektrisch leitfähigem Material, mindestens einer in dem Gehäuse (12) angeordneten Zelle (30) zum Speichern von elektrischer Energie und zwei durch das Gehäuse (12) angeordneten Anschlüssen (14, 16), wobei die Anschlüsse (14, 16) am Durchgang der Anschlüsse (14, 16) durch das Gehäuse (12) elektrisch von dem Gehäuse (12) isoliert sind, wobei die Anschlüsse (14, 16) eine Übertragung von elektrischer Energie zwischen der mindestens einen Speicherzelle (30) und der Außenseite des Geräts (10) ermöglichen, **dadurch gekennzeichnet, dass** das Gerät (10) ferner eine spezifische Komponente (Z1, Z2, Z3, 34, 41, 42) umfasst, die eine Impedanz bildet, die im Inneren des Gehäuses (12) angeordnet ist, einen ersten der Anschlüsse (14, 16) mit dem Gehäuse (12) verbindet, und ein Filter des Hochpasstyps bildet, das zum Evakuieren einer elektromagnetischen Störung, die dazu neigt, sich durch den ersten Anschluss (14, 16) auszubreiten und in das Gehäuse (12) einzudringen, zum Gehäuse (12) hin konfiguriert ist, wobei die spezifische Komponente (Z1, Z2, Z3, 34, 41, 42), die einen Kondensator (C) und einen Widerstand (R) in Reihe geschaltet umfasst, wobei der Widerstand (R) einen Wert von mehr als 1 Ohm hat, zum Ableiten der Energie der elektromagnetischen Störung konfiguriert ist.

2. Gerät nach Anspruch 1, **dadurch gekennzeichnet, dass** die Impedanz als erste Impedanz bezeichnet wird, und dadurch, dass es im Inneren des Gehäuses (12) eine zweite Impedanz (Z2) umfasst, die mindestens eine Widerstandskomponente größer als 1 Ohm aufweist und einen zweiten der Anschlüsse (14) mit dem Gehäuse (12) verbindet, wobei die zweite Impedanz (Z2) ein Filter des Hochpasstyps bildet, das zum Evakuieren einer elektromagnetischen Störung, die dazu neigt, sich durch den zweiten Anschluss (14) auszubreiten, zum Gehäuse (12) hin konfiguriert ist.

3. Gerät nach einem der vorherigen Ansprüche, **dadurch gekennzeichnet, dass** es im Inneren des Gehäuses (12) eine dritte Impedanz (Z3) umfasst, die mindestens eine Widerstandskomponente größer als 1 Ohm aufweist und ein Filter des Hochpasstyps bildet und die beiden Anschlüsse (14, 16) miteinander verbindet.

4. Gerät nach einem der vorherigen Ansprüche, **dadurch gekennzeichnet, dass** es im Inneren des Gehäuses mehrere mit den Anschlüssen (14, 16) verbundene Zellen (30) zum Speichern von elektrischer Energie und Impedanzen (34) umfasst, die jeweils mit einer der elektrischen Zellen (30) zum Speichern von elektrischer Energie assoziiert sind und mindestens eine Widerstandskomponente größer als 1 Ohm aufweisen.

5. Gerät nach einem der vorherigen Ansprüche, **dadurch gekennzeichnet, dass** die Impedanz(en) (Z1, Z2, Z3, 34) jeweils mehrere parallel geschaltete Kondensatoren (Ca, Cb) umfassen.

6. Gerät nach einem der vorherigen Ansprüche, **dadurch gekennzeichnet, dass** die Impedanz(en) (Z1, Z2, Z3, 34) jeweils mehrere parallel geschaltete Widerstände (Ra, Rb) umfassen.

7. Gerät nach einem der vorherigen Ansprüche, **dadurch gekennzeichnet, dass** die Impedanz(en) (Z1, Z2, Z3, 34) jeweils mehrere in Reihe oder parallel geschaltete Induktivitäten L umfassen.

8. Gerät nach einem der vorherigen Ansprüche, **dadurch gekennzeichnet, dass** es ein Mittel (22) zum Vergleichen einer am gemeinsamen Punkt des Kondensators (C) und des Widerstands (R) anliegenden Spannung mit einer Referenzspannung und ein Mittel (24) zum Informieren über eine Differenz zwischen der am gemeinsamen Punkt anliegenden Spannung und der Referenzspannung umfasst.

9. Gerät nach einem der vorherigen Ansprüche, **dadurch gekennzeichnet, dass** es ein Mittel (22) zum Vergleichen einer am gemeinsamen Punkt des Kondensators (C) und des Widerstands (R) der ersten Impedanz (Z1) anliegenden Spannung und einer am gemeinsamen Punkt des Kondensators (C) und des Widerstands (R) der zweiten Impedanz (Z2) anliegenden Spannung und ein Mittel (24) zum Informieren über eine Differenz zwischen einem gemessenen Ergebnis des Vergleichs und einem erwarteten Ergebnis umfasst.

10. Gerät nach Anspruch 1, **dadurch gekennzeichnet, dass** es eine zusätzliche Impedanz, vierte Impedanz (41) genannt, umfasst, die ein Tiefpassfilter bildet, das in Reihe mit einem Leiter geschaltet ist, der einen ersten der Anschlüsse (14, 16) und die mindestens eine Speicherzelle (30) verbindet.

11. Gerät nach Anspruch 10, **dadurch gekennzeichnet, dass** das Gerät eine fünfte Impedanz (42) umfasst, die ein Tiefpassfilter bildet, das in Reihe mit einem Leiter geschaltet ist, der einen zweiten der Anschlüsse (14, 16) und die mindestens eine Speicherzelle (30) verbindet.

12. Gerät nach Anspruch 11, **dadurch gekennzeichnet, dass** die vierte (41) und die fünfte (42) Impedanz jeweils durch eine zwischen der mindestens einen Zelle (30) und dem jeweiligen Anschluss (14, 16) in Reihe geschaltete Wicklung gebildet werden, und dadurch, dass das Gerät einen der vierten (41) und der fünften (42) Impedanz gemeinsamen Magnetkreis (43) umfasst.

13. Gerät nach einem der Ansprüche 10 bis 12, **dadurch gekennzeichnet, dass** es ein Prüfmittel (22, 45, 46) zum Prüfen der vierten Impedanz (41) und gegebenenfalls der fünften Impedanz (42) umfasst.

14. Gerät nach Anspruch 13, **dadurch gekennzeichnet, dass** die vierte Impedanz (41) und gegebenenfalls die fünfte Impedanz (42) jeweils durch eine Primärwicklung gebildet werden, und dadurch, dass das Prüfmittel eine Sekundärwicklung (45, 46) umfasst, die mit der Primärwicklung für jede der vierten Impedanz und gegebenenfalls der fünften Impedanz gekoppelt ist.

15. Gerät nach einem von Anspruch 10 oder Anspruch 11, **dadurch gekennzeichnet, dass** die vierte Impedanz (41) und gegebenenfalls die fünfte Impedanz (42) aus einem ferromagnetischen Material gebildet sind, das den Leiter umgibt, der den betrachteten Anschluss (14, 16) und die mindestens eine Speicherzelle (30) verbindet.

## Claims

1. An electrical energy accumulation device (10) comprising a housing (12) made of electrically conductive material, at least one electrical energy storage cell (30) that is arranged in the housing (12) and two terminals (14, 16) that are arranged through the housing (12), the terminals (14, 16) being electrically insulated from the housing (12) at the passage of the terminals (14, 16) through the housing (12), the terminals (14, 16) allowing electrical energy to be transferred between the at least one storage cell (30) and the exterior of the device (10), **characterized in that** the device (10) further comprises a specific component (Z1, Z2, Z3, 34, 41, 42) forming an impedance arranged inside the housing (12), connecting a first of the terminals (14, 16) to the housing (12), and forming a high-pass filter that is configured to channel away, toward the housing (12), an electromagnetic interference which tends to propagate through the first terminal (14, 16) and to enter the housing (12), the specific component (Z1, Z2, Z3, 34, 41, 42), comprising a capacitor (C) and a resistor (R) that are connected in series, the resistor (R) having a value that is higher than 1 ohm, being configured to dissipate the energy of the electromagnetic interference.

2. The device according to claim 1, **characterized in that** the impedance is referred to as the first impedance, and **in that** the device comprises, inside the housing (12), a second impedance (Z2) having at least one resistive component that is higher than 1 ohm and connecting a second of the terminals (14) to the housing (12), the second impedance (Z2) forming a high-pass filter that is configured to channel away, toward the housing (12), an electromagnetic interference which tends to propagate through the second terminal (14).

3. The device according to any of the preceding claims, **characterized in that** it comprises, inside the housing (12), a third impedance (Z3) having at least one resistive component that is higher than 1 ohm, forming a high-pass filter and connecting the two terminals (14, 16) to one another.

4. The device according to any of the preceding claims, **characterized in that** it comprises, inside the housing, multiple electrical energy storage cells (30) that are connected to the terminals (14, 16) and impedances (34), each of which is associated with one of the electrical energy storage cells (30) and has at least one resistive component that is higher than 1 ohm.

5. The device according to any of the preceding claims, **characterized in that** the one or more impedances (Z1, Z2, Z3, 34) each comprise multiple capacitors (Ca, Cb) that are connected in parallel.

6. The device according to any of the preceding claims, **characterized in that** the one or more impedances (Z1, Z2, Z3, 34) each comprise multiple resistors (Ra, Rb) that are connected in parallel.

7. The device according to one of the preceding claims, **characterized in that** the one or more impedances (Z1, Z2, Z3, 34) each comprise multiple inductors L that are connected in series or in parallel.

8. The device according to one of the preceding claims, **characterized in that** it comprises a means (22) for comparing a voltage that is present at the common point of the capacitor (C) and of the resistor (R) with a reference voltage and a means (24) for informing of a difference between the voltage that is present at the common point and the reference voltage.

9. The device according to any of the preceding claims, **characterized in that** it comprises a means (22) for comparing a voltage that is present at the common point of the capacitor (C) and of the resistor (R) of the first impedance (Z1) and a voltage that is present at the common point of the capacitor (C) and of the resistor (R) of the second impedance (Z2), and a means (24) for informing of a difference between a measured result of the comparison and an expected result.

10. The device according to claim 1, **characterized in that** the device comprises an additional impedance, referred to as the fourth impedance (41), forming a low-pass filter that is connected in series with a conductor connecting a first of the terminals (14, 16) and the at least one storage cell (30).

11. The device according to claim 10, **characterized in that** the device comprises a fifth impedance (42) forming a low-pass filter that is connected in series with a conductor connecting a second of the terminals (14, 16) and the at least one storage cell (30).

12. The device according to claim 11, **characterized in that** the fourth (41) and fifth (42) impedances are each formed of a winding that is connected in series between the at least one cell (30) and the respective terminal (14, 16), and **in that** the device comprises a magnetic circuit (43) that is common to the fourth (41) and fifth (42) impedances.

13. The device according to one of claims 1 to 12, **characterized in that** it comprises a means (22, 45, 46) for testing the fourth impedance (41) and, if applicable, the fifth impedance (42).

14. The device according to claim 13, **characterized in that** the fourth impedance (41) and, if applicable, the fifth impedance (42) are each formed of a primary winding and **in that** the test means comprises a secondary winding (45, 46) that is coupled to the primary winding for each of the fourth impedance and, if applicable, the fifth impedance.

15. The device according to either of claims 10 or 11, **characterized in that** the fourth impedance (41) and, if applicable, the fifth impedance (42) are formed of a ferromagnetic material surrounding the conductor connecting the terminal (14, 16) in question and the at least one storage cell (30).

FIG.1

FIG.2a    FIG.2b    FIG.2c

FIG.3a

FIG.3b

FIG.4

FIG.5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011013429 A1